# EUROPÄISCHE PATENTSCHRIFT

(11) **EP 1 913 638 B1**
(45) Veröffentlichungstag und Bekanntmachung des Hinweises auf die Patenterteilung: **03.05.2017**
(21) Anmeldenummer: 06792706.1
(22) Anmeldetag: 04.08.2006
(51) Int. Cl.: H01L 27/30

(54) **FLÄCHENHAFTER ORGANISCHER FOTODETEKTOR UND RÖNTCHENSTHRALFLACHBILDDETEKTOR**
FLAT ORGANIC PHOTODETECTOR AND FLAT X-RAY DETECTOR
PHOTODETECTEUR ORGANIQUE PLAN ET DETECTEUR D'IMAGES PLAN À RAYONS X

(30) Priorität: 08.08.2005 DE 102005037289
(43) Veröffentlichungstag der Anmeldung: 23.04.2008
(73) Patentinhaber: Siemens Healthcare GmbH, 91052 Erlangen (DE)
(72) Erfinder: FÜRST, Jens, 91093 Hessdorf (DE); HENSELER, Debora, 91052 Erlangen (DE); WITTMANN, Georg, 91074 Herzogenaurach (DE)
(86) Internationale Anmeldenummer: PCT/EP2006/065079
(87) Internationale Veröffentlichungsnummer: WO 2007/017474

(56) Entgegenhaltungen:
- WO-A2-2004/006350
- US-A1- 2004 016 923
- US-A1- 2005 045 808
- US-B1- 6 483 099

## Beschreibung

Fotodetektor, Röntgenstrahlenflachbilddetektor Die Erfindung betrifft einen flächenhaften organischen Fotodetektor und einen organischen Röntgenstrahlenflachbilddetektor.

Mit einem flächenhaften Fotodetektor wird auf den Fotodetektor auftreffendes Licht in elektrische Signale umgewandelt, die mit einer geeigneten Auswertevorrichtung in einen Bilddatensatz umgewandelt werden können. Flächenhafte organische Fotodetektoren, also Fotodetektoren mit einer fotoaktiven Schicht aus einem organischen Halbleitermaterial, stellen eine interessante Alternative zu Fotodetektoren mit einer fotoaktiven Schicht aus einem anorganischen Material dar.

Insbesondere die Herstellung eines Röntgenstrahlenflachbilddetektors mit einem organischen Fotodetektor kann relativ kostengünstig sein. Aufgabe eines Röntgenstrahlenflachbilddetektors ist es, eine durch ein Untersuchungsobjekt durchdringende und dabei geschwächte Röntgenstrahlung in entsprechende elektrische Signale umzuwandeln, die dann wiederum mit einer Auswertevorrichtung in einen Röntgenbilddatensatz umgewandelt werden können. Das dem Röntgenbilddatensatz zugeordnete Röntgenbild kann mit einem Sichtgerät visualisiert werden. Ein derartiger Röntgenstrahlenflachbilddetektor ist beispielsweise aus der US 2003/0025084 A1 bekannt.

Insbesondere großflächige Fotodetektoren, wie sie bisweilen für Röntgenstrahlenflachbilddetektoren gebraucht werden, können deshalb relativ kostengünstig hergestellt werden, weil die organischen Schichten des organischen Fotodetektors großflächig durch relativ kostengünstige Verfahren, wie,beispielsweise durch Rotationsbeschichtung (Spin-Coating), Rakel- oder Drucktechniken aufgebracht werden können.

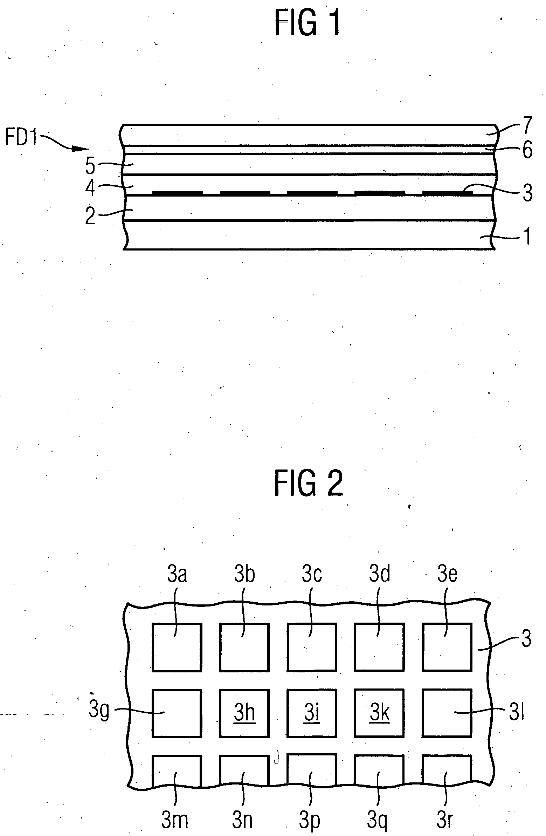

Die Figur 1 zeigt ausschnittsweise ein Beispiel eines flächenhaften organischen Fotodetektors FD1 zur Erläuterung der allgemeinen Problematik.

Der in der Figur 1 ausschnittsweise gezeigte Fotodetektor FD1 umfasst mehrere aneinander anschließende Schichten 1 bis 7. Der bekannte Fotodetektor FD1 umfasst ein flächenhaftes Substrat 1, in das matrixförmig, in der Figur 1 nicht dargestellte Transistoren eingebracht sind. Jeder der einzelnen Transistoren ist einem der Pixel des mit dem Fotodetektor FD1 aufzunehmenden Bildes zugeordnet.

Auf dem Substrat 1 ist eine Passivierungsschicht 2 aufgetragen, auf der wiederum eine flächenhafte und strukturierte Elektrode 3, die in der Draufsicht ausschnittsweise in der Figur 2 dargestellt ist, z.B. mittels eines Lithographie-Prozesses strukturiert ist. Die strukturierte Elektrode 3 besteht beispielsweise aus Gold, Platin, Palladium, Silber oder Indium-Zinn-Oxid.

Wie aus der Figur 2 ersichtlich ist, ist die Elektrode 3 matrixförmig strukturiert und umfasst mehrere Teilelektroden 3a bis 3r, die voneinander elektrisch isoliert sind. Jede der Teilelektroden 3a bis 3r ist mit jeweils einem der Transistoren des Substrats 1 elektrisch verbunden. Jede der Teilelektroden 3a bis 3r ist daher jeweils einem der Pixel des mit dem Fotodetektor FD1 aufzunehmenden Bildes zugeordnet.

Auf der flächenhaften und strukturierten Elektrode 3 ist flächenhaft eine organische Lochtransportschicht 4, z.B. aus Pedot:PSS, aufgetragen. Auf der flächenhaften organischen Lochtransportschicht 4 ist wiederum eine fotoaktive Schicht 5 aus einem organischen Halbleitermaterial, beispielsweise Poly-3-Hexylthiophen/PCBM, flächenhaft aufgetragen.

Der flächenhaften organischen fotoaktiven Schicht 5 schließt sich eine unstrukturierte, zumindest semitransparente flächenhafte Elektrode 6 an. Die flächenhafte Elektrode 6 ist z.B. eine dünne Metallschicht aus Calcium oder Silber. Um den Fotodetektor FD1 vor Beschädigung und Degration durch Sauerstoff und Feuchtigkeit zu schützen, ist schließlich eine Schutzschicht 7 auf der Elektrode 6 aufgetragen. Die Schutzschicht 7 besteht z.B. aus Glas, einem möglichst transparenten Polymer oder einem Mehrschichtsystem aus organischen Polymeren und anorganischen Barriereschichten wie Al₂O₃ oder Si₃N₄.

Soll ein Bild mit dem Fotodetektor FD1 aufgenommen werden, so durchdringt die dem Bild zugeordnete Lichtverteilung die Schutzschicht 7 und die zumindest semitransparente Elektrode 6 und wird durch die fotoaktive Schicht 5 in Verbindung mit der Lochtransportschicht 4 und den beiden Elektroden 6 und 3 in elektrische Signale umgewandelt, die mit den Transistoren des Substrats 1 ausgelesen werden. Die ausgelesenen Signale werden wiederum an eine in den Figuren nicht dargestellte, dem Fachmann aber bekannte Auswertevorrichtung weiter geleitet und zu einem Bilddatensatz verarbeitet. Der Bilddatensatz kann dann mit einem in den Figuren ebenfalls nicht dargestellten Sichtgerät als Bild visualisiert werden.

Das Bild ist aus mehreren Pixeln aufgebaut. Jede der Teilelektroden 3a bis 3r der strukturierten flächenhaften Elektrode 3 bzw. jeder der mit einer entsprechenden Teilelektrode verbundene Transistor des Substrats 1 ist einem dieser Pixel zugeordnet.

Die beiden organischen Schichten 4 und 5 haben eine relativ hohe Leitfähigkeit und daher eine relativ hohe Quanteneffizienz im Bereich von etwa 60% bis 85%. Da jedoch die beiden organischen Schichten 4 und 5 flächenhaft und unstrukturiert auf der strukturierten Elektrode 3 aufgebracht sind und die beiden organischen Schichten eine relativ hohe Querleitfähigkeit haben, d.h. eine Leitfähigkeit parallel zu ihren flächenhaften Ausdehnungen, kommt es zu einem relativ großen Übersprechen der für die jeweiligen Teilelektroden 3a bis 3r bzw. deren zugeordneten Transistoren des Substrats 1 bestimmten elektrischen Signale. Eine eingeschränkte Ortsauflösung des mit dem Fotodetektor FD1 aufgenommenen Bilds ist die Folge.

Die Aufgabe der Erfindung ist es daher, einen flächenhaften organischen Fotodetektor und einen Rötenstrahlenflachbilddetektor mit einem organischen Fotodetektor derart auszuführen, dass die Ortsauflösung des mit dem Fotodetektor aufgenommenen Bildes bzw. mit dem Rötenstrahlenflachbilddetektor aufgenommenen Röntgenbildes verbessert wird.

Die Aufgabe der Erfindung wird gelöst durch einen flächenhaften organischen Fotodetektor gemäß Anspruch 1, aufweisend eine strukturierte, mehrere Teilelektroden umfassende erste Elektrode, eine zweite Elektrode, wenigstens eine erste organische Schicht und eine zweite organische Schicht wobei die beiden organischen Schichten zwischen den beiden Elektroden angeordnet und entsprechend der ersten Elektrode strukturiert sind, sodass die beiden organischen Schichten in mehrere, den einzelnen Teilelektroden der ersten Elektrode zugeordneten aktive Bereiche unterteilt sind. Grundgedanke für den vorliegenden erfindungsgemäßen Fotodetektor ist es, dass die beiden organischen Schichten nicht unstrukturiert auf der strukturierten Elektrode, deren Teilelektroden jeweils einem Pixel des mit dem Fotodetektors aufzunehmenden Bildes zugeordnet sind, aufgetragen sind, wie dies nach dem Stand der Technik üblich ist, sondern dass die beiden organischen Schichten ebenfalls entsprechend der strukturierten Elektrode strukturiert sind. Durch die Strukturierung der organischen Schichten ist jeder der Teilelektroden der ersten Elektrode ein aktiver Bereich der organischen Schichten zugeordnet, d.h. jedem Pixel des mit dem Fotodetektor aufgenommen Bildes ist nicht nur eine Teilelektrode der ersten Elektrode zugeordnet, sondern auch ein aktiver Bereich der organischen Schichten. Dies schafft Voraussetzungen, dass sich die einzelnen, den Pixeln des Fotodetektors zugeordneten aktiven Bereichen möglichst wenig beeinflussen. Ein Übersprechen von dem aufzunehmenden Bild zugeordneten Signalen innerhalb der organischen Schichten kann somit zumindest stark verringert werden, wodurch sich die örtliche Auflösung des aufgenommenen Bildes verbessert.

Bei den beiden organischen Schichten handelt es sich um eine fotoaktive Schicht und um eine Lochtransportschicht aus organischen Materialen. Geeignete organische Materialien für die fotoaktive Schicht sind beispielsweise Poly-3-Hexylthiophen (P3HT) oder allgemein Poly-3-Alhylthiophen (P3AT) und als Loch transportierende Materialien PPVs oder als Elektron transportierende Materialien PCBM. Weitere organische Materialien sind u.a. CuPc/PTCBI, ZNPC/C60, konjugierte PolymerKomponenten oder Fulleren-Komponenten. Ein geeignetes organisches Material für die Lochtransportschicht ist z.B. auch Pedot:PSS.

Die aktiven Bereiche der organischen Schichten sind nach einer Variante des erfindungsgemäßen Fotodetektors durch Gräben voneinander getrennt. Die Gräben können vorteilhafterweise mit einem Laser in die organischen Schichten eingefügt werden. Aus fertigungstechnischen Gründen hat es sich als vorteilhaft herausgestellt, wenn die Gräben der beiden organischen Schichten gemäß bevorzugter Varianten des erfindungsgemäßen organischen Fotodetektors eine Breite kleiner als 50µm und/oder eine Breite größer als 5µm haben.

Bei dem erfindungsgemäßen flächenhaften organischen Fotodetektor trennt ein Zusatzmaterial die aktiven Bereiche der beiden organischen Schichten voneinander. Das Zusatzmaterial ist ein Fotolack, der bei der Herstellung des Fotodetektors zunächst auf die erste Elektrode aufgebracht wird und z.B. eine überhängende Struktur aufweist. Bei einer überhängenden Struktur hängen von der ersten Elektrode weiter entfernte Bereiche der Stege der Wallstruktur über die aktiven Bereiche ähnlich wie ein Pilz. "Überhängende Strukturen sind z.B. aus der Technologie für organische LEDs bekannt und werden dort auch als "Mushrooms" (Pilze) bezeichnet. Danach können die beiden organischen Schichten auf die mit dem Fotolack versehene erste Elektrode aufgebracht werden, sodass die einzelnen aktiven Bereiche der beiden organischen Schichten von dem Fotolack getrennt sind. Die Fotolackstruktur hat bevorzugt eine Breite kleiner als 20µm und/oder eine Breite größer als 2µm.

Nach einer besonders bevorzugten Ausführungsform des erfindungsgemäßen flächenhaften organischen Fotodetektors hat das Zusatzmaterial eine die organischen Materialien der organischen Schichten abweisende Eigenschaft. Beispiele eines solchen Materials sind ein fluorierter Fotolack oder ein Fotolack, auf dem ein fluorierendes Plasma aufgetragen wird. Bei der Herstellung des Fotodetektors wird der Fotolack an den Stellen auf die erste Elektrode aufgebracht, an denen die einzelnen aktiven Bereiche der organischen Schichten voneinander getrennt sein sollen. Durch die schlechte Benetzbarkeit z.B. des fluorierten Fotolacks werden die beiden organischen Schichten an den Stellen, an denen der fluorierte Fotolack aufgetragen ist unterbrochen, wodurch die organischen Schichten strukturiert werden. Die einzelnen Stege der Wallstruktur haben bevorzugt einen relativ flachen Winkel zur ersten Elektrode von ca. 3° bis 30°. Dadurch ist es möglich, die zweite Elektrode auf die organischen Schichten aufzudampfen oder aufzusputtern. Durch die relativ flachen Winkel sind außerdem Vorraussetzungen geschaffen, dass die zweite Elektrode nicht abreißt.

Bei den beiden Elektroden handelt es sich um ein Anoden- /Kathoden-Paar. Je nachdem, ob die erste Elektrode eine Kathode oder eine Anode ist, handelt es sich bei der ersten organischen Schicht entweder um die Lochtransportschicht oder um die fotoaktive Schicht.

Um den erfindungsgemäßen organischen Fotodetektor vor Verschmutzung, Beschädigung oder Degration zu schützen, ist nach einer vorteilhaften Ausführungsform des Fotodetektors auf die zweite Elektrode eine flächenhafte Schutzschicht aufgetragen.

Da die Verwendung organischer Fotodetektoren besonders interessant für Röntgenstrahlenflachbilddetektoren ist, ist es vorgesehen, den erfindungsgemäßen organischen Fotodetektor insbesondere als Röntgenstrahlenflachbilddetektor zu verwenden. Ein solcher erfindungsgemäßer Röntgenstrahlenflachbilddetektor umfasst eine Röntgenstrahlen absorbierende Schicht, die auf den erfindungsgemäßen flächenhaften organischen Fotodetektor aufgetragen ist. Eine geeignete Röntgenstrahlen absorbierende Schicht, die auch als Szintillator bezeichnet wird, umfasst beispielsweise Cäsiumjodid.

Weiterhin offenbart ist ein Verfahren zum Herstellen eines flächenhaften organischen Fotodetektors, der eine strukturierte, mehrere Teilelektroden umfassende erste Elektrode, eine zweite Elektrode, eine erste organische Schicht und eine zweite organische Schicht aufweist, wobei die beiden organischen Schichten zwischen den beiden Elektroden angeordnet und entsprechend der ersten Elektrode strukturiert sind, sodass die beiden organischen Schichten in mehrere, den einzelnen Teilelektroden der ersten Elektrode zugeordnete aktive Bereiche unterteilt sind, aufweisend folgende Verfahrensschritte:
- Aufbringen eines Zwischenmaterials auf die strukturierte erste Elektrode, wobei das Zwischenmaterial eine Wallstruktur entsprechend der Struktur der beiden organischen Schichten aufweist,
- flächenhaftes Auftragen der ersten organischen Schicht auf die erste flächenhafte Elektrode,
- flächenhaftes Auftragen der zweiten organischen Schicht auf die erste organische Schicht und
- flächenhaftes Auftragen der zweiten Elektrode auf die zweite organische Schicht.

Eine Schwierigkeit bei der Strukturierung der organischen Schichten ist es, dass die organischen Schichten beim Strukturierungsprozess nicht beschädigt werden. Aufgrund des Verfahrens wird vorgeschlagen, den erfindungsgemäßen organischen Fotodetektor schichtweise herzustellen. Zunächst wird die strukturierte erste Elektrode, z.B. wie es bereits üblich ist, hergestellt. Auf die strukturierte erste Elektrode wird anschließend das Zwischenmaterial, das ein Fotolack ist, insbesondere mittels eines lithographischen Prozesses aufgebracht. Durch die Wallstruktur sollen beim anschließenden Auftragen der beiden organischen Schichten in die aktive Bereiche getrennt werden.

Bei der Wallstruktur handelt es sich gemäß einer vorteilhaften Variante des Verfahrens um eine überhängenden Struktur. Verfahren zum Herstellen einer überhängenden Struktur für eine Fotolackstruktur sind beispielsweise bei der Herstellung von organischen LEDs bekannt.

Anschließend werden die beiden organischen Schichten, bei denen es sich um die fotoaktiven organische Schicht und die organische Lochtransportschicht handelt, nacheinander auf die strukturierte erste Elektrode, auf der die Wallstruktur aufgetragen ist, aufgetragen. Durch die überhängende Wallstruktur werden dabei die beiden organischen Schichten in mehrere aktive voneinander unabhängige Bereiche unterteilt. Die Wallstruktur wird bevorzugt derart ausgeführt, dass aktive Bereiche wenigstens 2µm und maximal 20µm voneinander getrennt sind.

Auf die beiden organischen Schichten wird schließlich noch die zweite Elektrode aufgetragen. Zusätzlich kann noch die zweite Elektrode mit einer möglichst transparenten Schutzschicht, z.B. aus Glas oder einem möglichst transparenten Kunststoff überzogen werden.

Gemäß einer weiteren bevorzugten Ausführungsform des Verfahrens hat das Zwischenmaterial eine die organischen Materialien der organischen Schichten abweisende Eigenschaft. Ein Beispiel eines solchen Fotolacks ist ein fluorierter Fotolack. Aufgrund der abweisenden Eigenschaft des Fotolacks werden beim Auftragen der organischen Schichten auf die erste Elektrode diese schlecht benetzt, wodurch die Strukturierung der organischen Schichten entsteht.

Weiterhin offenbart ist ein Verfahren zum Herstellen eines flächenhafte organischen Fotodetektors, aufweisend folgende Verfahrensschritte:
- Flächenhaftes Auftragen einer ersten organischen Schicht auf eine strukturierte erste Elektrode, die aufgrund der Strukturierung mehrer Teilelektroden umfasst,
- flächenhaftes Auftragen einer zweiten organischen Schicht auf die erste organische Schicht,
- Einfügen einer Grabenstruktur in die beiden organischen Schichten mit einem Laser, wobei die Grabenstruktur der Struktur der ersten Elektrode entspricht, und
- flächenhaftes Auftragen einer zweiten Elektrode auf die zweite organische Schicht.

Nachdem die beiden organischen Schichten auf die strukturierte erste Elektrode aufgetragen wurden, werden also die Gräben, die bevorzugt eine Breite kleiner als 50µm und/oder größer als 5µm haben, in die organischen Schichten gelasert (Laser-Patterning-Prozess). Wird insbesondere ein Laser mit Licht im sichtbaren oder nahen UV-Bereich verwendet, so ist eine Schädigung der organischen Schichten aufgrund des Laserns nicht zu erwarten.

Um den Fotodetektor zu schützen, kann zusätzlich noch die zweite Elektrode mit einer möglichst transparenten Schutzschicht, z.B. aus Glas oder einem möglichst transparenten Kunststoff überzogen werden.

Ausführungsbeispiele der Erfindung sind in den beigefügten schematischen Zeichnungen dargestellt. Es zeigen:
- Fig. 1: Eine teilweise Schnittansicht eines organischen Fotodetektors,
- Fig. 2: eine ausschnittsweise Draufsicht eines Teils des in der Fig. 1 gezeigten Fotodetektors,
- Fig. 3 bis 6: verschiedene Stadien der Herstellung eines organischen Fotodetektors,
- Fig. 7 bis 10: verschiedene Stadien der Herstellung eines weiteren erfindungsgemäßen organischen Fotodetektors,
- Fig. 11 bis 14: verschiedene Stadien der Herstellung eines weiteren erfindungsgemäßen organischen Fotodetektors und
- Fig. 15: einen erfindungsgemäßen Rötenstrahlenflachbilddetektor.

Die Figuren 1 und 2 wurden bereits in der Beschreibungseinleitung beschrieben.

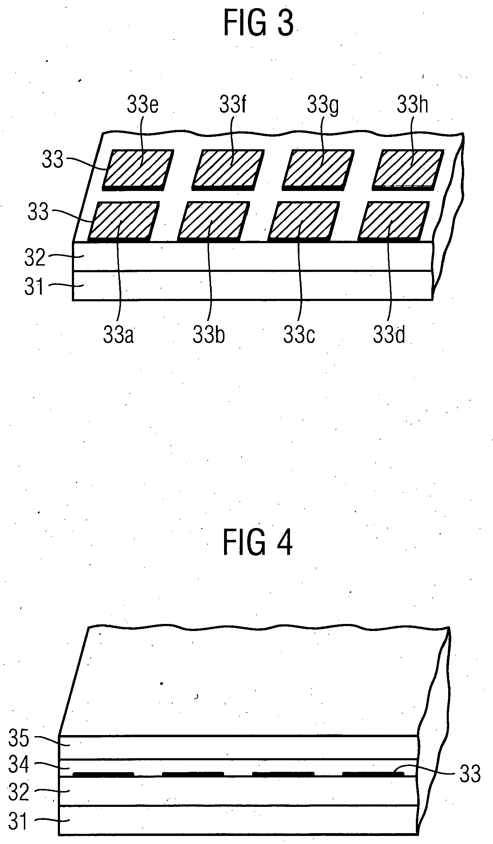

Mit den Figuren 3 bis 6 wird die Herstellung eines Fotodetektor FD2 veranschaulicht:

Die Figur 3 zeigt teilweise ein Substrat 31 mit aufgetragener Passivierungsschicht 32. Das Substrat 31 umfasst mehrere in den Figuren nicht näher dargestellte matrixförmig angeordnete Transistoren, die im Falle des vorliegenden Ausführungsbeispiels Dünnschichttransistoren (TFTs) sind. Grundsätzlich kann das Substrat 31 auch andere Transistoren, wie insbesondere organische Feld-Effekt-Transistoren, umfassen.

Auf der Passivierungsschicht 32 ist eine strukturierte flächenhafte Elektrode 33, die im Falle des vorliegenden Ausführungsbeispiels aus Gold gefertigt ist, aufgetragen. Die Elektrode 33 ist matrixförmig strukturiert, wodurch sie in mehrere elektrisch voneinander isolierte Teilelektroden 33a bis 33h unterteilt ist. Jede der Teilelektroden 33a bis 33h ist mit einem der Transistoren des Substrats 31 elektrisch verbunden und ist somit jeweils einem Pixel eines mit dem herzustellenden Fotodetektor FD2 aufzunehmenden Bilds zugeordnet.

Anschließend wird auf die strukturierte Elektrode 33 flächenhaft, z.B. durch Rotationsbeschichtung (Spin-Coating), Rakel- oder Drucktechniken, eine Lochtransportschicht 34 aus einem organischen Material aufgetragen. Als organisches Material wird im Falle des vorliegenden Ausführungsbeispiels Pedot:PSS verwendet. Auf die Lochtransportschicht 34 wird anschließend eine fotoaktive Schicht 35 aus einem organischen Halbleitermaterial, im Falle des vorliegenden Ausführungsbeispiels P3HT/PCBM, aufgetragen, wie dies in Figur 4 veranschaulicht ist.

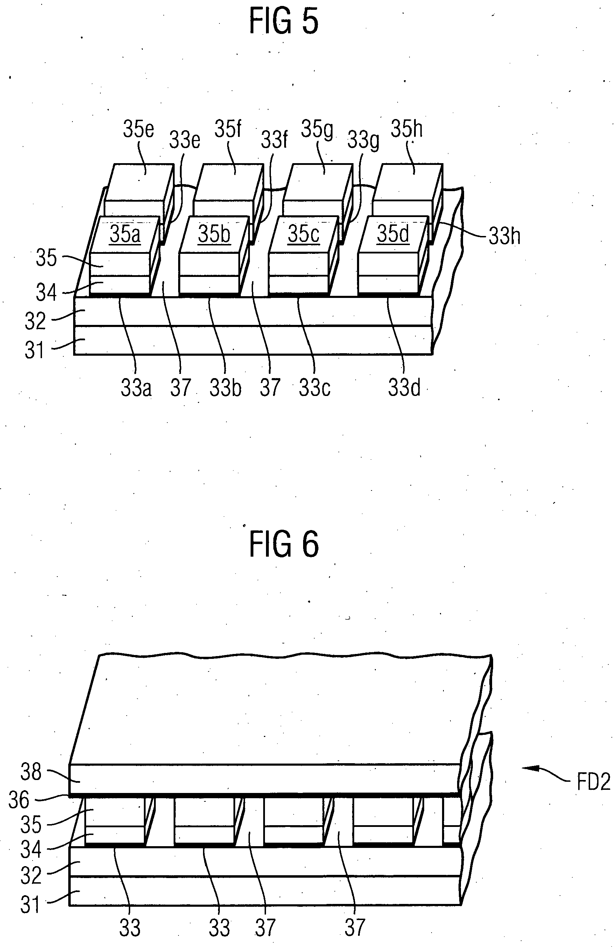

Bevor nun die fotoaktive Schicht 35 mit einer flächenhaften Elektrode 36 versehen wird, werden die beiden organischen Schichten, d.h. die fotoaktive Schicht 35 und die Lochtransportschicht 34, mit einem in den Figuren nicht dargestellten Laser strukturiert, wie dies in der Figur 5 dargestellt ist.

Mit dem Laser werden im Falle des vorliegenden Ausführungsbeispiels Gräben 37 mit einer Breite von 5µm bis maximal 50µm in die beiden organischen Schichten 34 und 35 gelasert. Die Gräben 37 werden derart platziert und sind tief genug, sodass die Lochtransportschicht 34 und die fotoaktive Schicht 35 in voneinander getrennte aktive Bereiche 35a bis 35h unterteilt wird, von denen jeweils ein aktiver Bereich 35a bis 35h mit jeweils einer Teilelektroden 33a bis 33h der Elektrode 33 zusammenwirkt, jedoch mit benachbarten Teilelektroden 33a bis 33h möglichst nicht elektrisch verbunden sind. Um die beiden organischen Schichten 34 und 35 möglichst nicht zu beschädigen, wird im Falle des vorliegenden Ausführungsbeispiels ein Laser mit einem Licht im sichtbaren oder nahen UV-Bereich gewählt.

Anschließend wird auf die strukturierte fotoaktive Schicht 35 die unstrukturierte flächenhafte Elektrode 36 aufgetragen, die im Falle des vorliegenden Ausführungsbeispiels mit einer Schutzschicht 38 aus Glas versehen ist. Dies ist in der Figur 6 dargestellt.

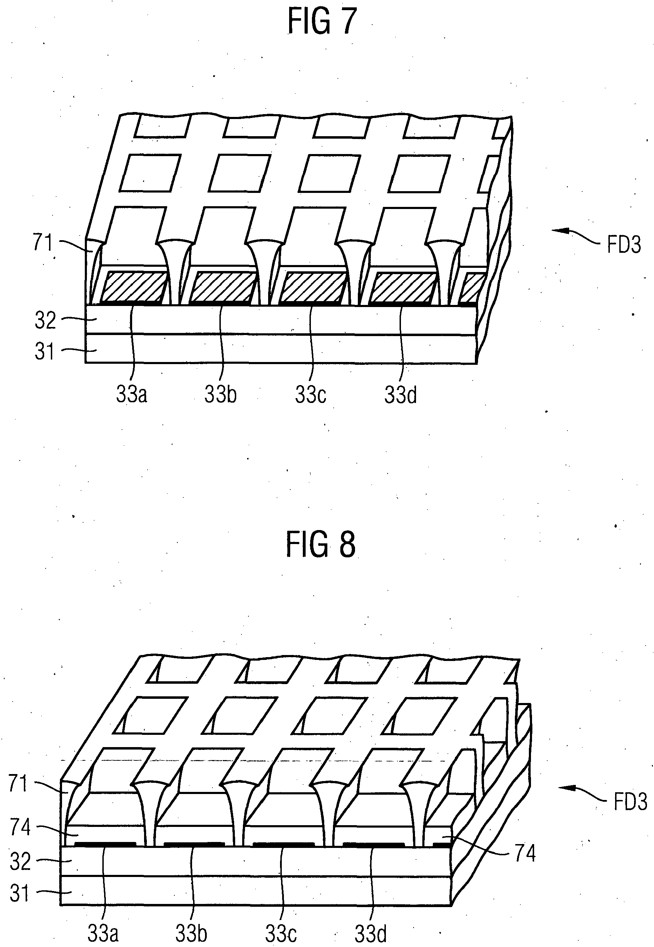

Die Figuren 7 bis 10 veranschaulichen ein Verfahren zum Herstellen eines erfindungsgemäßen Fotodetektors FD3. Wenn folgend nicht anders beschrieben, sind Bestandteile des in den Figuren 7 bis 10 gezeigten Fotodetektors FD3, welche mit Bestandteilen des in den Figuren 3 bis 6 gezeigten Fotodetektors FD2 weitgehend bau- und funktionsgleich sind, mit denselben Bezugszeichen versehen.

Im Gegensatz zu dem in den Figuren 3 bis 6 veranschaulichten Herstellungsverfahren wird bei dem erfindungsgemäßen Herstellungsverfahren zunächst auf die strukturierte Elektrode 33 ein Fotolack aufgetragen, der mittels eines z.B. bei der Herstellung von organischen LEDs oder anorganischen Bauteilen bekannten lithographischen Prozesses matrixförmig strukturiert wird. Die entstehende Fotolackstruktur 71 ist in der Figur 7 näher dargestellt.

Wie es aus der Figur 7 ersichtlich ist, handelt es sich bei der Fotolackstruktur 71 im Falle des vorliegenden Ausführungsbeispiels um eine überhängende Struktur, bei der Fotolack in den Bereichen, in denen die einzelnen Teilelektroden 33a bis 33h voneinander elektrisch isoliert sind, aufgetragen ist und im Wesentlichen die aktiven Bereiche der einzelnen Teilelektroden 33a bis 33h frei von Fotolack sind. Bei einer überhängenden Struktur hängen von der Elektrode 33 weiter entfernte Bereiche der Fotolackstruktur 71 über die Teilelektroden 33a - 33h. Im Falle des vorliegenden Ausführungsbeispiels hat die überhängende Fotolackstruktur 71 eine Breite von 2µm bis maximal 20µm.

Anschließend wird auf die mit der Fotolackstruktur 71 versehene strukturierte Elektrode 33 eine Lochtransportschicht 74 aus einem organischen Material aufgetragen. Als organisches Material wird im Falle des vorliegenden Ausführungsbeispiels Pedot:PSS verwendet. Die mit der Lochtransportschicht 74 versehene Elektrode 33 ist in der Figur 8 gezeigt.

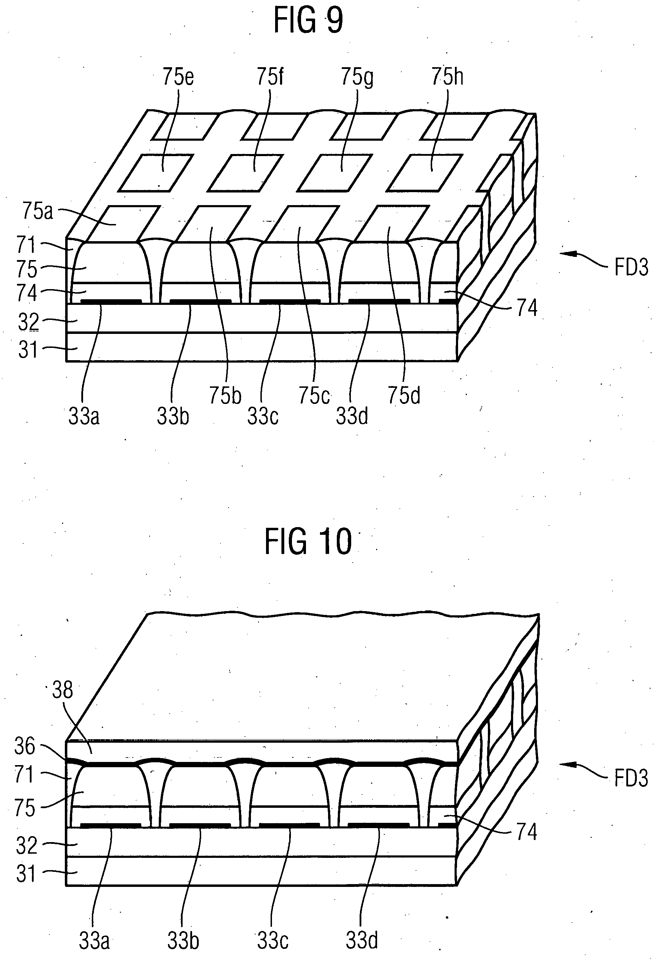

Auf die Lochtransportschicht 74 wird anschließend eine fotoaktive Schicht 75 aus einem organischen Halbleitermaterial, im Falle des vorliegenden Ausführungsbeispiels P3HT/PCBM, aufgetragen, wie dies in der Figur 9 veranschaulicht ist.

Wie es den Figuren 8 und 9 entnommen werden kann, verursacht die Fotolackstruktur 71, dass die Lochtransportschicht 74 und die fotoaktive Schicht 75 in voneinander getrennte aktive Bereiche 75a bis 75h unterteilt wird, von denen jeweils ein aktiver Bereich 75a bis 75h mit jeweils einer Teilelektroden 33a bis 33h der Elektrode 33 zusammenwirkt, jedoch benachbarte Teilelektroden möglichst unbeeinflusst lässt.

Anschließend wird auf die fotoaktiven Schicht 75 eine unstrukturierte flächenhafte Elektrode 36 aufgetragen, die im Falle des vorliegenden Ausführungsbeispiels mit einer Schutzschicht 38 aus Glas versehen ist. Die ist in der Figur 10 gezeigt.

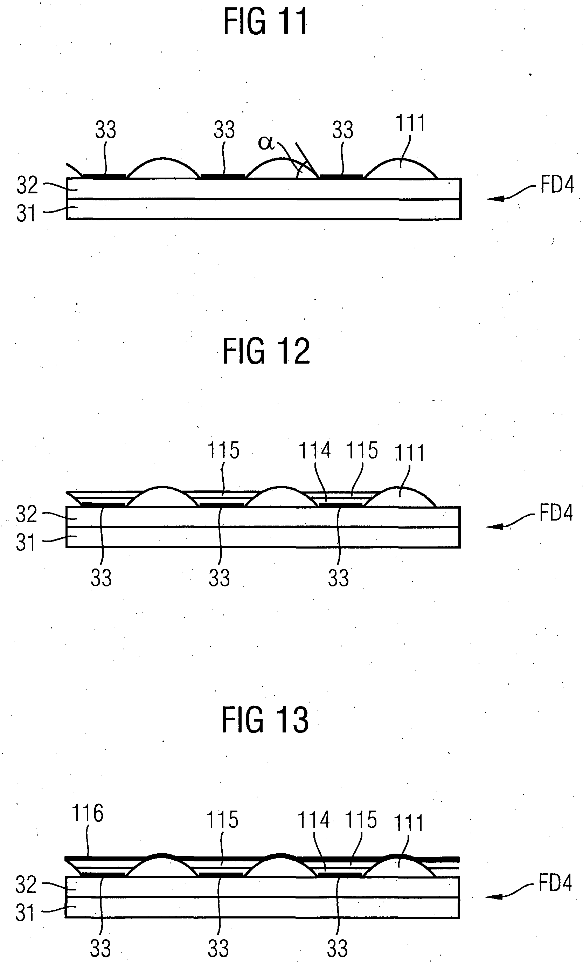

In den Figuren 11 bis 14 wird die Herstellung eines weiteren Flachbilddetektors FD4 dargestellt. Wenn folgend nicht anders beschrieben, sind Bestandteile des in den Figuren 11 bis 14 gezeigten Fotodetektors FD4, welche mit Bestandteilen des in den Figuren 3 bis 6 gezeigten Fotodetektors FD2 bzw. des in den Figuren 7 bis 10 gezeigten Fotodetektor FD3 weitgehend bau- und funktionsgleich sind, mit denselben Bezugszeichen versehen.

Im Gegensatz zu dem in den Figuren 3 bis 6 veranschaulichten Herstellungsverfahren wird bei dem in den Figuren 11 bis 13 dargestellten Herstellungsverfahren zunächst auf die strukturierte Elektrode 33 ein fluorierter Fotolack aufgetragen. Der fluorierte Fotolack hat die Eigenschaft, dass er schlecht von den organischen Materialien für die fotoaktive Schicht und die Lochtransportschicht des Fotodetektors FD4 benetzt wird. Der fluorierte Fotolack wird im Wesentlichen an den Stellen aufgetragen, die die Teilelektroden 33a bis 33h der ersten Elektrode 33 voneinander trennen. Dadurch entsteht eine Wallstruktur 111, die im Falle des vorliegenden Ausführungsbeispiels eine vertikale Ausdehnung von ca. 0,5µm bis 50µm hat. Des Weiteren hat die Wallstruktur 111 im Falle des vorliegenden Ausführungsbeispiels eine gerundete Ausdehnung, wobei der Winkel α zwischen der ersten Elektrode 33 und der Oberfläche der Wallstruktur 111 in etwa 3° bis 30° beträgt. Alternativ kann die schlechte Benetzbarkeit des Fotolacks der Wallstruktur 111 auch dadurch erreicht werden, dass zunächst die Wallstruktur 111 auf die Elektrode 33 aufgebracht wird, wobei die Wallstruktur 111 aus einem vorzugsweise isolierenden Material besteht, das nicht notwendigerweise die Eigenschaft hat, organische Materialien zu entnetzen. Anschließend wird diese Wallstruktur z.B. mit einem fluorierenden Plasma versehen; dieses hat wiederum eine entnetzende Eigenschaft.

Anschließend wird auf die mit der Wallstruktur 111 versehene strukturierte Elektrode 33 eine Lochtransportschicht 114 aus einem organischen Material aufgetragen, auf die wiederum eine fotoaktive Schicht 115 aus einem organischen Halbleitermaterial, im Falle des vorliegenden Ausführungsbeispiels P3HT/PCBM, aufgetragen wird. Dies ist in der Figur 12 veranschaulicht. Als organisches Material wird im Falle des vorliegenden Ausführungsbeispiels Pedot:PSS verwendet. Die Lochtransportschicht 114 hat eine vertikale Ausdehnung von etwa 10nm bis 100nm und die fotoaktive Schicht 115 hat eine vertikale Ausdehnung von etwa 100nm bis 1000nm.

Dadurch, dass der Fotolack der Wallstruktur 111 eine auf die organischen Materialen der Lochtransportschicht 114 und der fotoaktiven Schicht 115 entnetzende Wirkung ausübt, werden die Lochtransportschicht 114 und die fotoaktive Schicht 115 in aktive Bereiche unterteilt, von denen jeweils einer Teilelektrode 33a bis 33h der Elektrode 33 zugeordnet ist.

Anschließend wird auf die fotoaktive Schicht 115 eine unstrukturierte flächenhafte Elektrode 116 aufgedampft oder aufgesputtert. Die flächenhafte Elektrode 116 bildet im Falle des vorliegenden Ausführungsbeispiels die durch den Fotolack, der Lochtransportschicht 114 und der fotoaktiven Schicht 115 gebildete Oberflächenstruktur nach. Durch die gerundete Ausdehnung der Wallstruktur 111 ist es möglich, auch bei einer relativ dünnen Lochtransportschicht 114 und einer relativ dünnen fotoaktiven Schicht 115 ein Abreißen der Elektrode 116 zu vermeiden. Die aufgedampfte bzw. aufgesputterte Elektrode 116 ist in der Figur 13 gezeigt.

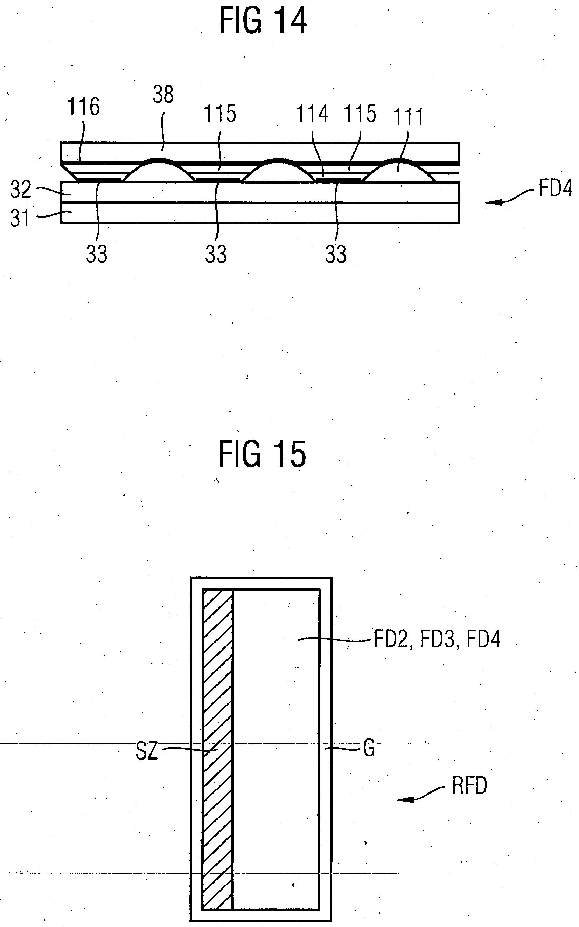

Um den Fotodetektor FD4 z.B. vor Verschmutzung oder Beschädigung zu schützen, ist die Elektrode 116 im Falle des vorliegenden Ausführungsbeispiels mit einer Schutzschicht 38 aus Glas versehen. Dies ist in der Figur 14 gezeigt.

Die Figur 15 zeigt einen erfindungsgemäßen Rötenstrahlenflachbilddetektor RFD. Der Rötenstrahlenflachbilddetektor RFD umfasst im Wesentlichen den Fotodetektor FD2, FD3 oder FD4, eine Röntgenstrahlen absorbierende Schicht SZ, die im Falle des vorliegenden Ausführungsbeispiels Cäsiumjodid umfasst und auf der Schutzschicht 38 des Fotodetektors FD2, FD3 bzw. FD4 aufgetragen ist, und ein Gehäuse G, das den Fotodetektor FD2, FD3 bzw. FD4 mit aufgetragener Röntgenstrahlen absorbierender Schicht SZ umgibt. Das Gehäuse G ist zumindest an der der Röntgenstrahlen absorbierenden Schicht SZ zugewandten Seite aus einem möglichst Röntgenstrahlen transparenten Material, z.B. Aluminium, gefertigt.

Obwohl die vorliegende Erfindung anhand bevorzugter Ausführungsbeispiele beschrieben wurde, ist die Erfindung nicht auf diese beschränkt, sondern auf vielfältige Weise modifizierbar.

## Patentansprüche

1. Flächenhafter organischer Fotodetektor, aufweisend eine strukturierte, mehrere Teilelektroden (33a-33h) umfassende erste Elektrode (33), eine zweite Elektrode (36, 116), wenigstens eine erste organische Schicht (74, 114) und eine zweite organische Schicht (75, 115), wobei die beiden organischen Schichten (74, 75, 114, 115) zwischen den beiden Elektroden (33, 36) angeordnet und entsprechend der ersten Elektrode (33) strukturiert sind, sodass die beiden organischen Schichten (74, 75, 114, 115) in mehrere, den einzelnen Teilelektroden (33a-33h) der ersten Elektrode (33) zugeordnete aktive Bereiche (75a-75h), die jeweils aus gleichem organischen Material sind, unterteilt sind,
wobei jeder der Teilelektroden (33a-33h) der ersten Elektrode (33) ein aktiver Bereich (75a-75h) der organischen Schichten (74, 75, 114, 115) zugeordnet ist,
wobei zumindest eine organische Schicht (74, 75, 114, 115) eine Lochtransportschicht ist und eine organische Schicht aus fotoaktivem Material ist und die zweite Elektrode (36,116) eine unstrukturierte Schicht ist, wobei die aktiven Bereiche (75a-75h) der beiden organischen Schichten (74, 75, 114, 115) durch Zusatzmaterial voneinander getrennt sind,
wobei das Zusatzmaterial ein Fotolack ist.

2. Flächenhafter organischer Fotodetektor nach Anspruch 1, bei dem die Gräben (37) eine Breite kleiner als 50µm und/oder eine Breite größer als 5µm haben.

3. Flächenhafter organischer Fotodetektor nach Anspruch 1 oder 2, wobei das Zusatzmaterial eine überhängende Struktur (71) aufweist.

4. Flächenhafter organischer Fotodetektor nach einem der vorstehenden Ansprüche, bei dem das Zusatzmaterial eine die organischen Materialien der organischen Schichten abweisende Eigenschaft aufweist.

5. Flächenhafter organischer Fotodetektor nach einem der Ansprüche 1 bis 4, bei dem auf die zweite Elektrode (36, 116) eine flächenhafte Schutzschicht (38) aufgetragen ist.

6. Röntgenstrahlenflachbilddetektor mit einer Röntgenstrahlen absorbierenden Schicht (SZ), die auf einem flächenhaften organischen Fotodetektor (FD2, FD3, FD4) nach einem der Ansprüche 1 bis 5 angeordnet ist.

## Claims

1. Laminar organic photodetector, having a structured first electrode (33) comprising a plurality of sub-electrodes (33a-33h), a second electrode (36, 116), at least one first organic layer (74, 114) and a second organic layer (75, 115), wherein the two organic layers (74, 75, 114, 115) are arranged between the two electrodes (33, 36) and are structured corresponding to the first electrode (33), such that the two organic layers (74, 75, 114, 115) are subdivided into a plurality of active regions (75a-75h) which are each made from the same organic material and are associated with the individual sub-electrodes (33a-33h) of the first electrode (33),
wherein an active region (75a-75h) of the organic layers (74, 75, 114, 115) is associated with each of the sub-electrodes (33a-33h) of the first electrode (33), wherein at least one organic layer (74, 75, 114, 115) is a hole transport layer and an organic layer is made of photoactive material and the second electrode (36, 116) is an unstructured layer, wherein the active regions (75a-75h) of the two organic layers (74, 75, 114, 115) are separated from one another by additional material, wherein the additional material is a photoresist.

2. Laminar organic photodetector according to claim 1, in which the trenches (37) have a width smaller than 50 µm and/or a width greater than 5 µm.

3. Laminar organic photodetector according to claim 1 or 2,
wherein the additional material has an overhanging structure (71).

4. Laminar organic photodetector according to one of the preceding claims, in which the additional material has a property of repelling the organic materials of the organic layers.

5. Laminar organic photodetector according to of claims 1 to 4, in which a laminar protective layer (38) is applied to the second electrode (36, 116).

6. X-ray flat panel detector with an X-ray-absorbing layer (SZ), which layer is applied to a laminar organic photodetector (FD2, FD3, FD4) according to of claims 1 to 5.

## Revendications

1. Photodétecteur organique, plan, comportant une première électrode (33), structurée et comportant plusieurs sous-électrodes (33a-33h), une deuxième électrode (36, 116), au moins une première couche (74, 114) organique et une deuxième couche (75, 115) organique, les deux couches (74, 75, 114, 115) organiques étant disposées entre les deux électrodes (33, 36) et étant structurées conformément à la première électrode (33) de manière à subdiviser les deux couches (74, 75, 114, 115) organiques en plusieurs régions (75a-75h) actives, qui sont associées aux sous-électrodes (33a-33h) individuelles de la première électrode (33) et qui sont dans la même matière organique,
dans lequel une région (75a-75h) active des couches (74, 75, 114, 115) organiques est associée à chacune des sous-électrodes (33a-33h) de la première électrode (33), dans lequel au moins une couche (74, 75, 114, 115) organique est une couche de transport de trous et une couche organique est en une matière photoactive et la deuxième électrode (36, 116) est une couche non structurée, les régions (75a-75h) actives des deux couches (74, 75, 114, 115) organiques étant séparées les unes les autres par de la matière supplémentaire, dans lequel la matière supplémentaire est un vernis photosensible.

2. Photodétecteur organique, plan suivant la revendication 1,
dans lequel les sillons (37) ont une largeur plus petite que 50 µm et/ou une largeur plus grande que 5 µm.

3. Photodétecteur organique, plan suivant la revendication 1 ou 2, dans lequel la matière supplémentaire a une structure (71) en porte à faux.

4. Photodétecteur organique, plan suivant l'une des revendications précédentes, dans lequel la matière supplémentaire a une propriété repoussant les matières organiques des couches organiques.

5. Photodétecteur organique, plan suivant l'une des revendications 1 à 4, dans lequel une couche (38) de protection plane est déposée sur la deuxième électrode (36, 116).

6. Détecteur d'image plan de rayons X ayant une couche (SZ) absorbant les rayons X, qui est disposée sur un photodétecteur (FD2, FD3, FD4) organique plan suivant l'une des revendications 1 à 5.
